# EUROPÄISCHE PATENTSCHRIFT

(11) **EP 2 111 091 B1**
(45) Veröffentlichungstag und Bekanntmachung des Hinweises auf die Patenterteilung: **06.08.2014**
(21) Anmeldenummer: 09154322.3
(22) Anmeldetag: 04.03.2009
(51) Int. Cl.: H05K 13/00, H05K 13/04

(54) **Anordnung zum Transport von Substraten, Anordnung zum Handhaben von Substraten, Anordnung zum Herstellen elektronischer Baugruppen sowie Verfahren zum Handhaben von Substraten**
Assembly for transporting substrates, assembly for handling substrates, assembly for producing electronic assemblies and method for handling substrates
Agencement de transport de substrats, agencement de manipulation de substrats, agencement de fabrication de composants électroniques ainsi que procédé de manipulation de substrats

(30) Priorität: 16.04.2008 DE 102008019102
(43) Veröffentlichungstag der Anmeldung: 21.10.2009
(73) Patentinhaber: ASM Assembly Systems GmbH & Co. KG, 81379 München (DE)
(72) Erfinder: Mehdianpour, Mohammad, 81829, München (DE); Müller, Werner, 83607, Holzkirchen (DE)
(74) Vertreter: Dilg, Haeusler, Schindelmann Patentanwaltsgesellschaft mbH

(56) Entgegenhaltungen:
- WO-A2-98/49646
- DE-A1- 3 630 178
- DE-A1-102009 015 769

## Beschreibung

Die Erfindung betrifft eine Anordnung zum Transport von Substraten, eine Anordnung zum Handhaben von Substraten, eine Anordnung zum Herstellen elektronischer Baugruppen, sowie Verfahren zum Handhaben von Substraten, insbesondere zum Bestücken der Substrate mit Bauelementen.

Bei der Herstellung elektronischer Baugruppen werden Substrate, beispielsweise Leiterplatten mit diversen Bauelementen bestückt. Im Bereich der Fertigung werden hierfür so genannte Bestückautomaten eingesetzt, welche die bereitgestellten Bauelemente mittels einer entsprechenden Positionier- und Bestückvorrichtung entnehmen und auf den Substraten an vordefinierten Positionen platzieren. Derartige Bestückautomaten können als "stand-alone"-Geräte betrieben werden, werden aber oftmals mit einem Transportsystem für die Substrate verbunden und zu Fertigungslinien zusammengefasst, wobei eine Fertigungslinie neben dem Bestückautomaten auch weitere Einrichtungen, wie beispielsweise Leiterplattendrucker, Lötofen oder Inspektionsautomaten, umfassen kann. Derartige Fertigungslinien sind im Allgemeinen durch eine starre Verkettung der einzelnen, die Linie bildenden Komponenten mit vergleichsweise hohem Automatisierungsgrad gekennzeichnet.

Aus der Offenlegungsschrift DE 100 23 358 A1 oder DE 3630178 A1 ist eine Fertigungslinie für die Bestückung von Leiterplatten mit Bauelementen bekannt, welche neben mindestens einem Bestückmodul noch einen Leiterplattendrucker, sowie einen Lötofen umfasst. Die einzelnen Komponenten der Fertigungslinie werden dabei mittels eines integrierten Transportsystems für die Substrate verkettet.

Ferner ist in der Patentschrift US 5692292 A eine Fertigungslinie mit mehreren Bestückmodulen bekannt, welche ebenfalls mittels eines integrierten Transportsystems starr miteinander verbunden sind.

Es ist die Aufgabe der vorliegenden Erfindung, eine Anordnung zum Transport von Substraten, eine Anordnung zum Handhaben von Substraten, eine Anordnung zum Herstellen elektronischer Baugruppen sowie Verfahren zum Handhaben von Substraten zu liefern, mittels derer die Flexibilität sowie die Bestückleistung einer Fertigungslinie erhöht werden kann.

Diese Aufgabe wird durch eine Anordnung zum Transport von Substraten, eine Anordnung zum Handhaben von Substraten, eine Anordnung zum Herstellen elektronischer Baugruppen, sowie Verfahren zum Handhaben von Substraten gemäß den unabhängigen Ansprüchen gelöst. Vorteilhafte Ausgestaltungen sind Gegenstand der abhängigen Ansprüche.

Die erfindungsgemäße Anordnung zum Transport von Substraten, welche mit Bauelementen bestückbar sind, umfasst ein Logistikmodul, welches zum Transport der Substrate bei einer Bestückungslinie ausgestaltet ist, sowie eine erste Verbindungseinrichtung, welche derart ausgestaltet ist, dass Substrate zur Bearbeitung vom Logistikmodul an ein erstes Robotermodul übergebbar sind, wobei die erste Verbindungseinrichtung zum An- und/oder Abkoppeln des ersten Robotermoduls während eines Betriebes des Logistikmoduls ausgestaltet ist.

Ein An- oder Abkoppeln des ersten Robotermoduls an das Logistikmodul während des laufenden Betriebs des Logistikmoduls kann erforderlich werden, wenn beispielsweise das Robotermodul eine nicht einfach zu behebende Störung aufweist oder wenn die Bestückungslinie zumindest teilweise umgerüstet werden muss. Anstatt die Störung direkt an der Fertigungslinie zu beheben ist es in diesen Fällen vorteilhaft, das Robotermodul auf einfache Art und Weise von dem Logistikmodul abzukoppeln, wobei der Betrieb des Logistikmoduls sowie der verbleibenden Fertigungslinie durch den Abkoppelvorgang nicht unterbrochen wird. Dies bedeutet einerseits, dass das Logistikmodul während des An- oder Abkoppelns nicht ausgeschaltet werden muss. Andererseits folgt daraus, dass die verbleibenden Transportabschnitte des Logistikmoduls weiterbetrieben werden können, so dass die Versorgung weiterer angeschlossener Robotermodule mit Substraten sichergestellt ist und nicht unterbrochen wird. Indem auch während des An- und Abkoppelns eines Robotermoduls ein im Wesentlichen unterbrechungsfreier Betrieb des Logistikmoduls ermöglicht wird, können weitere Teile der Bestückungslinie, beispielsweise weitere an das Logistikmodul angeschlossene Robotermodule, weiterbetrieben werden, so dass ein Stillstand der gesamten Bestückungslinie hierdurch vermieden werden kann. Dies führt dazu, dass die Effizienz der gesamten Bestückungslinie und damit der Durchsatz an Substraten je Zeiteinheit deutlich gesteigert werden können.

Nach der Behebung der Störung kann das abgekoppelte Robotermodul wieder an das Logistikmodul angekoppelt werden, ohne dabei den Betrieb des Logistikmoduls, d.h. die Versorgung der übrigen Robotermodule mit Substraten, zu unterbrechen.

In einer vorteilhaften Weiterbildung ist die Verbindungseinrichtung derart ausgestaltet, dass bearbeitete Substrate vom Robotermodul an das Logistikmodul übergebbar sind.

Dies hat den Vorteil, dass mit Hilfe der Verbindungseinrichtung nicht nur die Versorgung des ersten Robotermoduls mit Substraten gewährleistet wird, sondern auch der Abtransport der bereits bearbeiteten Substrate über das selbe Logistikmodul bewerkstelligt werden kann. Das Logistikmodul dient damit sowohl der Versorgung der Robotermodule mit Substraten als auch dem Abtransport fertig bearbeiteter Substrate von dem jeweiligen Robotermodul.

In einer weiteren vorteilhaften Weiterbildung weist das Logistikmodul eine weitere Verbindungseinrichtung auf, mit der ein weiteres Robotermodul an- oder abkoppelbar ist, so dass je nach Kopplung des ersten oder zweiten Robotermoduls eine Funktionalität der Bestückungslinie erhalten bleibt.

Hierbei weist die Bestückungslinie hinsichtlich der benötigten Funktionen zumindest eine einfache Redundanz auf. Wird ein Robotermodul von dem Logistikmodul abgekoppelt und steht somit für die Ausführung bestimmter Funktionen in der Bestückungslinie nicht mehr zur Verfügung, so können aufgrund der Redundanz diese Funktionen von einem anderen Robotermodul übernommen oder auf mehrere weitere Robotermodule verteilt werden. Hierdurch wird sichergestellt, dass die gesamte Funktionalität der Bestückungslinie auch bei Abkoppeln eines Robotermoduls erhalten bleibt.

In einer weiteren Ausgestaltung weist die Verbindungseinrichtung Zuführmittel auf, welche zur Zuführung von Betriebsstoffen vom Logistikmodul zum Robotermodul ausgestaltet sind.

Unter dem Begriff Betriebsstoffe sind beispielsweise Druckluft, Strom oder Informationen zu verstehen, welche ein Robotermodul zur Ausführbarkeit seiner Funktionalität benötigt. Diese Betriebsstoffe können über das Logistikmodul für jedes Robotermodul zentral bereitgestellt werden. Die Anschlüsse für diese Betriebsstoffe können beispielsweise im Chassis des Logistikmoduls vorgesehen sein, so dass ein anzukoppelndes Robotermodul schnell und einfach angeschlossen werden kann. Dabei ist es auch möglich, Anschlüsse für verschiedene Betriebsstoffe sowohl auf Seiten des Logistikmoduls als auch auf Seiten des Robotermoduls auf eine gemeinsame Anschlussleiste zu legen. Hierdurch kann der Aufwand für das An- und Abkoppeln eines Robotermoduls weiter reduziert werden.

In einer weiteren Ausgestaltung der Anordnung ist das Logistikmodul mit einer Liniensteuerung verbunden. Jedes Robotermodul weist dabei eine ihm zugeordnete Steuereinheit auf, mit der zumindest eine Funktion des jeweiligen Robotermoduls steuerbar ist, wobei die Verbindungseinrichtung zum Datenaustausch zwischen der Liniensteuerung einerseits und einer ausgewählten Steuereinheit andererseits ausgebildet ist.

Der Datenaustausch zwischen einer Liniensteuerung des Logistikmoduls einerseits und einer autarken Steuereinheit eines Robotermoduls andererseits ermöglicht eine dezentrale Steuerungsarchitektur, bei der übergeordnete Funktionen, beispielsweise die Auftragsreihenfolgeplanung, von der Liniensteuerung ausgeführt werden, wohingegen lokale Funktionen eines jeden Robotermoduls, beispielsweise die Berechnung und Steuerung von Bewegungsabläufen, von der dem jeweiligen Robotermodul zugeordneten Steuereinheit ausgeführt werden. Hierdurch ist es ferner möglich, das Robotermodul auch in einem vom Logistikmodul abgekoppelten Zustand autark zu betreiben, beispielsweise im Rahmen von Funktionstests beim Aufrüsten, Warten oder Instandhalten des jeweiligen Robotermoduls.

Die erfindungsgemäße Anordnung zum Handhaben von Substraten umfasst ein erstes Robotermodul, welches zum Handhaben der Substrate ausgestaltet ist, sowie eine erste Verbindungseinrichtung, welche derart ausgestaltet ist, dass Substrate zur Bearbeitung von einem Logistikmodul einer Bestückungslinie an das erste Robotermodul übergebbar sind, wobei die erste Verbindungseinrichtung zum An- und/oder Abkoppeln des ersten Robotermoduls während eines Betriebes des Logistikmoduls ausgestaltet ist.

Hinsichtlich der Vorteile, welche die An- oder Abkoppelbarkeit des ersten Robotermoduls mit sich bringt, wird auf die obigen Ausführungen das entsprechende Logistikmodul betreffend verwiesen.

In einer vorteilhaften Ausgestaltung der Anordnung ist eine zweite Verbindungseinrichtung vorgesehen, mit der ein zweites Robotermodul an das Logistikmodul an- und/oder abkoppelbar ist, so dass je nach Koppelung des ersten oder zweiten Robotermoduls eine Funktionalität der Bestückungslinie erhalten bleibt.

Wie eingangs bereits angemerkt kann mittels eines zweiten Robotermoduls, welches an das Logistikmodul angekoppelt wird, eine Redundanz der Fertigungslinie realisiert werden. Bei Ausfall eines der beiden Robotermodule können die davon betroffenen Funktionen von dem anderen Robotermodul übernommen oder, falls mehr als zwei Robotermodule an dem Logistikmodul angekoppelt sind, auf weitere Robotermodule verteilt werden. Somit ist sichergestellt, dass die gesamte Funktionalität der Bestückungslinie auch bei Abkoppeln eines Robotermoduls aufrechterhalten wird.

In einer weiteren Ausgestaltung weist die Verbindungseinrichtung Zuführmittel auf, welche zur Zuführung von Betriebsstoffen vom Logistikmodul zum Robotermodul ausgestaltet sind.

Hinsichtlich der sich daraus ergebenden Vorteile wird auf die obigen Ausführungen das Logistikmodul betreffend verwiesen.

In einer weiteren Ausgestaltung ist das Logistikmodul mit einer Liniensteuerung verbunden. Jedes Robotermodul weist dabei eine ihm zugeordnete Steuereinheit auf, mit der zumindest eine Funktion des angekoppelten Robotermoduls steuerbar ist, wobei die Verbindungseinrichtung zum Datenaustausch zwischen der Liniensteuerung einerseits und einer ausgewählten Steuereinheit andererseits ausgebildet ist.

Hinsichtlich der Vorteile der sich daraus ergebenden dezentrale Steuerungsarchitektur der Fertigungslinie wird an dieser Stelle auf die oben bereits ausgeführten Argumente verwiesen.

In einer vorteilhaften Weiterbildung ist ein abgekoppeltes Robotermodul unabhängig vom Logistikmodul betreibbar.

Ein wesentlicher Vorteil für das Robotermodul, welcher sich aus der dezentrale Steuerungsarchitektur ergibt, besteht sicherlich darin, dass dieses auch in einem vom Logistikmodul abgekoppelten Zustand als "stand-alone"-Einheit autark von der restliche Linie betrieben werden kann. Damit ist es beispielsweise möglich, Funktionstests oder Wartungs- und Instandhaltungsarbeiten offline, also im abgekoppelten Zustand vom Logistikmodul, durchzuführen, so dass die Fertigungslinie hierdurch zwar ggf. hinsichtlich ihrer Leistung, nicht aber hinsichtlich der Gesamtfunktionalität beeinträchtigt wird. Der laufende Betrieb der Linie kann - bei reduzierter Leistung - weiter aufrechterhalten werden, ein reperaturbedingter Stillstand der Linie wird somit vermieden.

In einer weiteren vorteilhaften Weiterbildung weist das Robotermodul mehrere Rollen auf, mittels derer es in einer Richtung quer zum Logistikmodul verfahrbar ist.

Durch die Verwendung von Rollen zum Bewegen des Robotermoduls kann der An- bzw. Abkoppelvorgang des Robotermoduls an bzw. von dem Logistikmodul auf einfache Art und Weist ohne großen Aufwand von nur einem Maschinenbediener ausgeführt werden. Die Robotermodule sind somit leicht auf dem Hallenboden beweglich und können beispielsweise zum Zweck der Wartung oder Reparatur schnell und einfach in andere Bereiche der Fertigungshalle verbracht werden. Im angekoppelten Zustand können für einen sicheren Stand des Robotermoduls beispielsweise die Rollen arretiert werden oder aber das Robotermodul mittels ausfahrbarer Füße gestützt werden.

In einer vorteilhaften Weiterbildung ist das Robotermodul zum Aufbringen eines viskosen Mediums auf die Substrate ausgebildet.

Bei dem viskosen Medium kann es sich beispielsweise um Klebstoffe zur Fixierung von Bauelementen oder um Lotpaste handeln. Beispielsweise wird bei der SMD-Technologie (Surface Mounted Devices) zur Herstellung elektronischer Baugruppen ein Substrat, beispielsweise eine Leiterplatte, an dafür vorgesehenen Positionen mit Lotpaste bedruckt, auf die anschließend die Bauelemente aufgesetzt werden. Das Aufbringen der Lotpaste kann beispielsweise im Siebdruckverfahren erfolgen. Klebstoffe können über einen Kleberoboter aufgebracht werden. Dabei ist es möglich, Lotpaste und/oder Klebstoffe als Betriebsstoffe über das Logistikmodul bereitzustellen. Die Substrate werden über das Logistikmodul an ein entsprechend ausgebildetes Robotermodul übergeben. Anschließend erfolgt der Lotpasten- bzw. Klebstoffauftrag. Fertige Substrate können danach wieder von dem Robotermodul an das Logistikmodul übergeben werden und weiteren Bearbeitungsschritten, beispielsweise einer Qualitätskontrolle oder der Bestückung mit Bauelementen, zugeführt werden.

In einer weiteren vorteilhaften Ausgestaltung ist das Robotermodul zur Kontrolle der Substrate ausgebildet.

Zur Kontrolle können optische Sensoren oder Kameras eingesetzt werden. Dabei wird beispielsweise kontrolliert, ob die Lotpaste auf den richtigen Stellen des Substrats aufgesetzt wurde. Ferner ist es auch möglich, bereits bestückte Substrate hinsichtlich der Vollständigkeit aber auch der Qualität sowie der Genauigkeit der Bestückung zu kontrollieren. Auch für den Kontrollvorgang werden zu kontrollierende Substrate aus dem Logistikmodul ausgeschleust und an das jeweilige Robotermodul übergeben. Nach der Kontrolle der Substrate werden diese wieder zum Weitertransport vom Robotermodul an das Logistikmodul übergeben und können einem nachfolgenden Bearbeitungsschritt zugeführt werden.

In einer vorteilhaften Weiterbildung ist das Robotermodul als Bestückautomat zum Bestücken der Substrate mit Bauelementen ausgebildet.

Auch zum Bestücken der Substrate mit Bauelementen können bei einem entsprechend ausgebildetem Robotermodul die Substrate vom Logistikmodul an das betreffende Robotermodul übergeben werden. Zum Bestücken werden die Bauelemente anschließend mithilfe einer Positioniervorrichtung an vordefinierten Positionen auf dem Substrat abgesetzt. Nach Beendigung des Bestückvorganges wird das bestückte Substrat vom Robotermodul wieder an das Logistikmodul übergeben und kann einem weiteren Bearbeitungsschritt, beispielsweise einer Kontrolle des Bestückergebnisses zugeführt werden.

In einer vorteilhaften Weiterbildung weist das Robotermodul zumindest einen Bestückkopf auf, welcher ausschließlich in einer x-Richtung, welche im Wesentlichen parallel zu einer Ebene des Substrats verläuft, bewegbar ist. Jeder Bestückkopf weist dabei mindestens eine Halteeinrichtung zum Handhaben der Bauelemente auf, welche in einer z-Richtung, die senkrecht zur Ebene des Substrats verläuft, relativ zum Bestückkopf verschiebbar am Bestückkopf angeordnet ist. Ferner weist das Robotermodul eine Verschiebeeinrichtung auf, mittels derer das zu bestückende Substrat ausschließlich in einer y-Richtung, welche im Wesentlichen senkrecht zur z-Richtung und winkelig zu der x-Richtung verläuft, bewegbar ist.

Die Bestückung der Substrate mit Bauelementen mittels eines Bestückkopfes, welche ausschließlich in einer ersten Richtung linear verfahrbar am Robotermodul angeordnet ist, stellt eine einfach und kostengünstig zu realisierende Möglichkeit dar. Um ein Bauelement auf seiner Bestückposition auf dem Substrat absetzen zu können, muss das Bauelement in einer Ebene parallel zur Ebene des Substrats relativ zum Substrat in zwei Richtungen x und y, welche winkelig zueinander verlaufen, positionierbar sein. Vorzugsweise verlaufen die beiden Richtungen x und y zueinander orthogonal und spannen dabei eine Ebene auf, welche parallel zur Ebene des Substrats ist. Gemeinsam mit der z-Richtung bilden sie ein Bezugssystem, welches vorzugsweise orthogonal ist. Zum Absetzen der Bauelemente auf dem Substrat sind die Halteeinrichtungen in der z-Richtung verschiebbar. Damit kann durch eine unabhängige Überlagerung der drei Bewegungsrichtungen jede Position auf dem zu bestückenden Substrat erreicht werden.

In der oben beschriebenen vorteilhaften Weiterbildung sind die Linearbewegungen entlang dieser beiden Richtungen auf den Bestückkopf sowie die aufgeteilt: Während der Bestückkopf ausschließlich in der x-Richtung verfahrbar ist, verfährt das zu bestückende Substrat mittels der Verschiebeeinrichtung ausschließlich in der y-Richtung. Diese Anordnung stellt eine einfach zu realisierende Möglichkeit für das Positioniersystem dar.

In einer weiteren vorteilhaften Weiterbildung weist das Robotermodul zumindest einen Bestückkopf auf, welcher ausschließlich in einer x-Richtung sowie in einer y-Richtung, welche im Wesentlichen parallel zu einer Ebene des Substrats sowie winkelig zueinander verlaufen, bewegbar am Robotermodul angeordnet ist. Dabei weist jeder Bestückkopf mindestens eine Halteeinrichtung zum Handhaben der Bauelemente auf, welche in einer z-Richtung, senkrecht zur Ebene des Substrats relativ zum Bestückkopf verschiebbar am Bestückkopf angeordnet ist.

Mithilfe einer derartigen Flächen-Positioniervorrichtung, bei der der Bestückkopf in einer Ebene parallel zur Ebene des Substrats positionierbar ist, kann auch bei ruhendem Substrat jede Position auf dem Substrat durch eine unabhängige Überlagerung der drei Bewegungsrichtungen erreicht werden. Hierdurch kann einerseits die Flexibilität des Robotermoduls beim Bestücken der Substrate deutlich erhöht werden, zum anderen eignet sich die Anordnung für leichte oder empfindliche Bauelemente, welche nach dem Bestückvorgang keinen hohen Beschleunigungen mehr ausgesetzt werden sollten, um ein mögliches Verrutschen auf dem Substrat zu vermeiden. Daher ist es in diesem Fällen vorteilhaft, wenn das Substrat beim Bestücken ruht und die Bewegungen in der x- und der y-Richtung durch den Bestückkopf ausgeführt werden.

In einer vorteilhaften Weiterbildung weist mindestens einer der Bestückköpfe mehrere Halteeinrichtungen auf, welche in einer Ebene parallel zur Ebene des Substrats angeordnet sind.

Durch die Verwendung mehrerer Halteeinrichtungen an einem Bestückkopf kann der relative Anteil der Verfahrzeiten des Bestückkopfes zwischen einem Abholbereich zum Aufnehmen von Bauelementen und der jeweiligen Bestückposition auf dem Substrat deutlich reduziert werden. Indem nacheinander zunächst mehrere Bauelemente aufgenommen werden, der Bestückkopf anschließend zum Substrat verfahren wird und dort mehrere Bauelemente nacheinander abgesetzt werden wird die Bestückleistung der Vorrichtung deutlich erhöht.

In einer weiteren Weiterbildung verfügt jede Halteeinrichtung mindestens eines der Bestückköpfe über einen eigenen Drehantrieb, mit dessen Hilfe ein aufgenommenes Bauelement um eine Achse senkrecht zur Ebene des Substrats drehbar ist.

Mit Hilfe des jeder Halteeinrichtung individuell zugeordneten Drehantriebs kann eine gegebenenfalls erforderliche Winkelkorrektur eines aufgenommenen Bauelements durchgeführt werden. Dieses Vorpositionieren kann gleichzeitig mit dem Verfahren des Bestückkopfes erfolgen, so dass der Zeitaufwand für den Bestückvorgang durch die Winkelkorrektur nicht weiter erhöht wird.

In einer weiteren vorteilhaften Weiterbildung verfügt jede Halteeinrichtung mindestens eines der Bestückköpfe über einen eigenen z-Antrieb, mit dessen Hilfe ein aufgenommenes Bauelement in der z-Richtung senkrecht zur Ebene des Substrates verfahrbar ist.

Mithilfe der jeder Halteeinrichtung individuell zugeordneten z-Antriebe können die aufgenommenen Bauelemente hinsichtlich ihrer Höhenlage über dem Substrat vor dem Absetzen der Bauelemente in der z-Richtung vorpositioniert werden. Diese Vorpositionierung kann - wie auch die Winkelpositionierung - während des Verfahrens des Bestückkopfes bzw. während der Positionierung der Winkellage erfolgen, so dass durch die Überlagerung dieser Teilprozesse die Zeitdauer für die Positionierung des Bauelementes reduziert wird. Die Bestückleistung der Vorrichtung kann dadurch weiter erhöht werden.

In einer weiteren vorteilhaften Weiterbildung weist mindestens einer der Bestückköpfe ein um eine Achse senkrecht zur Ebene des Substrats drehbaren Rotor auf. Ferner weist der Bestückkopf mindestens zwei Halteeinrichtungen auf, welche am Rotor angeordnet sind.

Mithilfe des Rotors sind die Halteeinrichtungen bei Drehung des Rotors in einer Ebene parallel zur Ebene des Substrats bewegbar. Diese Drehbewegung des Rotors kann dabei mit einer Verfahrbewegung des Bestückkopfes in der ersten Richtung und/oder der zweiten Richtung überlagert werden, so dass sich hierdurch beispielsweise Verfahrwege verkürzen lassen. Weiterhin resultiert aus einer derartigen Drehbewegung des Rotors eine geringere Krafteinwirkung auf die Vorrichtung als eine entsprechende Verfahrbewegung des Bestückkopfes, da beim Verfahren des gesamten Kopfes größere Massen bewegt werden müssen. Die Genauigkeit des Bestückvorganges kann dadurch weiter verbessert werden.

Die erfindungsgemäße Anordnung zum Herstellen elektronischer Baugruppen umfasst ein Logistikmodul nach einem der Ansprüche 1 bis 5 sowie zumindest ein mit dem Logistikmodul gekoppeltes Robotermodul nach einem der Ansprüche 6 bis 20, wobei das Robotermodul während des Betriebes des Logistikmoduls ankoppelbar und/oder abkoppelbar ist.

Zu den Vorteilen einer derartigen Anordnung zum Herstellen elektronischer Baugruppen wird auf die vorangegangenen Ausführungen verwiesen.

Bei dem erfindungsgemäßen Verfahren zum Handhaben von Substraten mittels einer Anordnung nach Anspruch 21, insbesondere zum Bestücken der Substrate mit Bauelementen, wobei die Anordnung ein Logistikmodul zum Transport der Substrate sowie mindestens ein Robotermodul zum Handhaben der Substrate umfasst, wird in einem ersten Schritt das Robotermodul von dem Logistikmodul abgemeldet und in einem zweiten Schritt das abgemeldete Robotermodul während des Betriebes des Logistikmoduls von diesem abgekoppelt.

Da der Abkoppelvorgang des Robotermoduls vom Logistikmodul während des laufenden Betriebes des Logistikmoduls durchgeführt werden kann, ist die Versorgung weiterer angekoppelter Robotermodule durch das Logistikmodul mit Substraten sichergestellt. Das Logistikmodul muss für den Abkoppelvorgang weder ausgeschaltet noch vollständig angehalten werden. Zumindest diejenigen Transportabschnitte, welche nicht direkt an dem abzukoppelnden Robotermodul angrenzen, können unterbrechungsfrei weiter betrieben werden. Damit können sowohl zu bearbeitende Substrate zu den übrigen angekoppelten Robotermodule transportiert werden, als auch bereits bearbeitete Substrate von den weiterhin angekoppelten Robotermodulen abgeholt und weitertransportiert werden.

In einer Ausgestaltung des Verfahrens weist die Anordnung eine Liniensteuerung zur Koordination der Abläufe zwischen dem Logistikmodul und dem mindestens einen Robotermodul auf, wobei das Robotermodul an der Liniensteuerung von dem Logistikmodul abgemeldet wird.

Ein an der Liniensteuerung durchführbarer Abmeldevorgang hat den Vorteil, dass er direkt vom Bedienpersonal der Linie durchgeführt werden kann. Auf dem Abmeldevorgang hin erfolgt eine Freigabe durch die Liniensteuerung, anschließend kann das Robotermodul von dem Logistikmodul abgekoppelt werden.

In einer weiteren Ausgestaltung des Verfahrens wird das Robotermodul nach dem Abkoppeln vom Logistikmodul abgerüstet und/oder gewartet.

Indem Rüstvorgänge oder Wartungsarbeiten nicht direkt an der Fertigungslinie, sondern in einem abgekoppelten Zustand des Robotermoduls durchgeführt werden, kann die Fertigungslinie weiterhin produktiv genutzt werden. Wartungsbedingte Stillstandszeiten der Fertigungslinie können somit deutlich reduziert werden.

In einem weiteren erfindungsgemäßen Verfahren zum Handhaben von Substraten mittels einer Anordnung nach Anspruch 21, insbesondere zum Bestücken der Substrate mit Bauelementen, wobei die Anordnung ein Logistikmodul zum Transport der Substrate sowie mindestens ein Robotermodul zum Handhaben der Substrate umfasst, wird in einem ersten Schritt das Robotermodul an einem Logistikmodul angemeldet. In einem zweiten Schritt wird das angemeldete Robotermodul während des Betriebes des Logistikmoduls an das Logistikmodul angekoppelt.

In einer vorteilhaften Weiterbildung des Verfahrens wird das Robotermodul vor dem Ankoppeln an das Logistikmodul gerüstet und/oder getestet.

Zu den Vorteilen des erfindungsgemäßen Verfahrens beim Ankoppeln des Robotermoduls an das Logistikmodul wird auf die Ausführungen des oben beschriebenen erfindungsgemäßen Verfahrens zum Abkoppeln des Robotermoduls vom Logistikmodul verwiesen.

Im Folgenden wird ein Ausführungsbeispiel der erfindungsgemäßen Anordnungen unter Bezug auf die beigefügten Figuren näher erläutert. Dabei zeigt:
- Figur 1: Eine schematische Darstellung eines modularen Fertigungssystems im Grundriss
- Figuren 2a und 2b: Schematische Darstellungen eines Ausschnitts des Logistikmoduls in Grund- und Aufriss
- Figuren 3a und 3b: Schematische Darstellungen eines Robotermoduls in der Ausgestaltungsform eines Bestückautomaten in Grund- und Aufriss
- Figuren 4a und 4b: Schematische Darstellungen eines Bestückkopfs zum streifenweisen Bestücken von Substraten in Grund und Aufriss

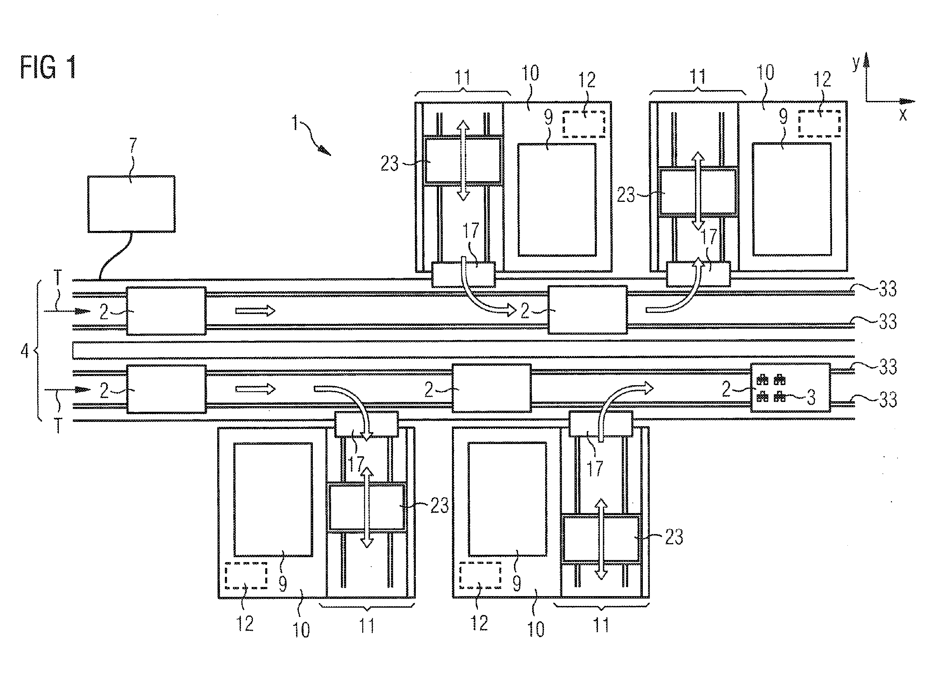

Figur 1 zeigt schematisch ein Fertigungssystem 1 zur Herstellung elektronischer Baugruppen. Dabei können beispielsweise Substrate 2 mit Bauelementen 3 bestückt werden. Das Fertigungssystem 1 ist modular aufgebaut und weist ein Logistikmodul 4 auf, welches zum Transport von Substraten, vorzugsweise Leiterplatten, in einer x-Richtung ausgebildet ist, sowie eine Mehrzahl von Robotermodulen 10, welche zum Bearbeiten bzw. zum Handhaben der Substrate 2 an das Logistikmodul 4 angekoppelt sind. Zur Steuerung des Fertigungssystems 1 ist eine Liniensteuerung 7 vorgesehen, welche beispielsweise die Bestimmung der Auftragsreihenfolge oder die Belegungsplanung der einzelnen Robotermodule 10 ausführt und daher vorzugsweise an das Logistikmodul 4 angeschlossen ist.

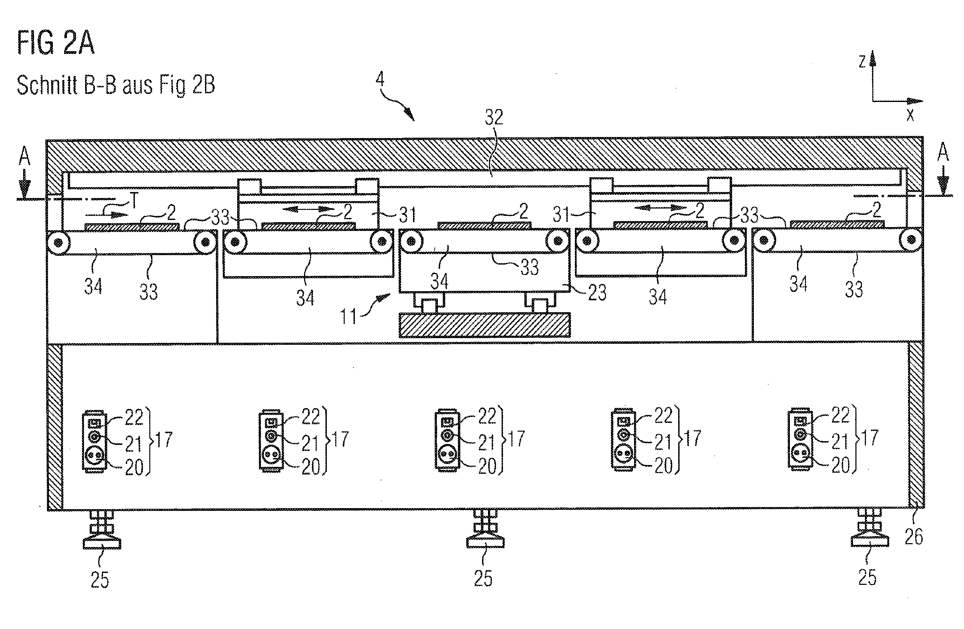

Das Logistikmodul 4 ist in als zweispuriges Transportsystem dargestellt, welches die Substrate 2 in einer Transportrichtung T transportiert. Es ist jedoch ebenso möglich, das Logistikmodul als einspuriges Transportsystem auszubilden. Die Kopplung zwischen dem Logistikmodul 4 und den einzelnen angekoppelten Robotermodulen 10 erfolgt durch eine jeweilige Verbindungseinrichtung 17, welche jeweils zwischen dem Logistikmodul 4 und dem jeweiligen Robotermodul 10 angeordnet ist. Mit Hilfe der Verbindungseinrichtung 17 können Substrate 2 zwischen dem Logistikmodul 4 und dem jeweiligen Robotermodul 10 transferiert werden. Weiterhin weist die Verbindungseinrichtung 17 auf Seiten des Logistikmoduls 4 auch Zuführmittel 20, 21, 22 (siehe Figur 2a) zur Zuführung von Betriebsstoffen für das jeweils angekoppelte Robotermodul 10 auf. Mittels dieser hier nicht näher dargestellten Schnittstellen werden beispielsweise Strom, Druckluft oder auch Informationen zur Verfügung gestellt, welche das Robotermodul 10 zur Ausführung seiner Aufgaben benötigt.

Jedes Robotermodul 10 weist eine ihm zugeordnete lokale Steuereinheit 12 auf, mit der zumindest eine Funktion des Robotermoduls 10 autark gesteuert werden kann. Mittels der Verbindungseinrichtung 17 können Daten zwischen der lokalen Steuereinheit 12 und der Liniensteuerung 7 ausgetauscht werden. Ferner verfügt jedes Robotermodul 10 über eine eigene Substrat-Transporteinrichtung 11, welche eine Verschiebeeinrichtung 23 aufweist, mittels der Substrate 2, welche von dem Logistikmodul 4 an das Robotermodul 10 übergeben wurden, innerhalb des Robotermoduls 10 in einer y-Richtung transportiert werden können. Die y-Richtung ist dabei quer zur Substrat-Transportrichtung x des Logistikmoduls 4 angeordnet. Vorzugsweise ist die y-Richtung orthogonal zur x-Richtung orientiert. Ist eine hohe Positioniergenauigkeit gefordert, so werden als Antrieb zum Verfahren der Verschiebeeinrichtung 23 vorteilhafter Weise Linearmotoren eingesetzt.

Weiterhin verfügt jedes Robotermodul 10 über eine Bearbeitungseinrichtung 9, mit der ein Substrat 2 dem Einsatzzweck des Robotermoduls 10 entsprechend bearbeitet werden kann. Auf Seiten des Robotermoduls 10 kann die Verschiebeeinrichtung 23 der Verbindungseinrichtung 17 zugeordnet werden. Ferner weist die Verbindungseinrichtung 17 Elemente auf, welche mit korrespondierenden Elementen der Zuführmittel 20, 21, 22 seitens des Logistikmoduls 4 verbunden werden können, um beispielsweise die Versorgung des Robotermoduls 10 mit Strom, Druckluft oder Steuerungsinformation zu gewährleisten.

Ein Robotermodul 10 kann dabei für verschiedene Ausführungszwecke vorgesehen sein, wobei die Bearbeitungseinrichtung 9 entsprechend dafür ausgebildet ist. Beispielsweise ist es möglich, ein Robotermodul 10 als Bestückautomat zum Bestücken von Substraten 2 mit Bauelementen 3 auszubilden. Es ist jedoch ebenso möglich, ein Robotermodul 10 als Leiterplattendrucker zum Aufbringen von Lotpaste auf die Substrate 2 oder als optisches Inspektionsmodul zum Kontrollieren der Substrate 2, beispielsweise des Lotauftrags oder der Bestückgenauigkeit, auszubilden. All diesen Ausführungsformen ist gemein, dass ein entsprechend ausgeführtes Robotermodul 10 möglichst flexibel an das Logistikmodul 4 angekoppelt werden kann.

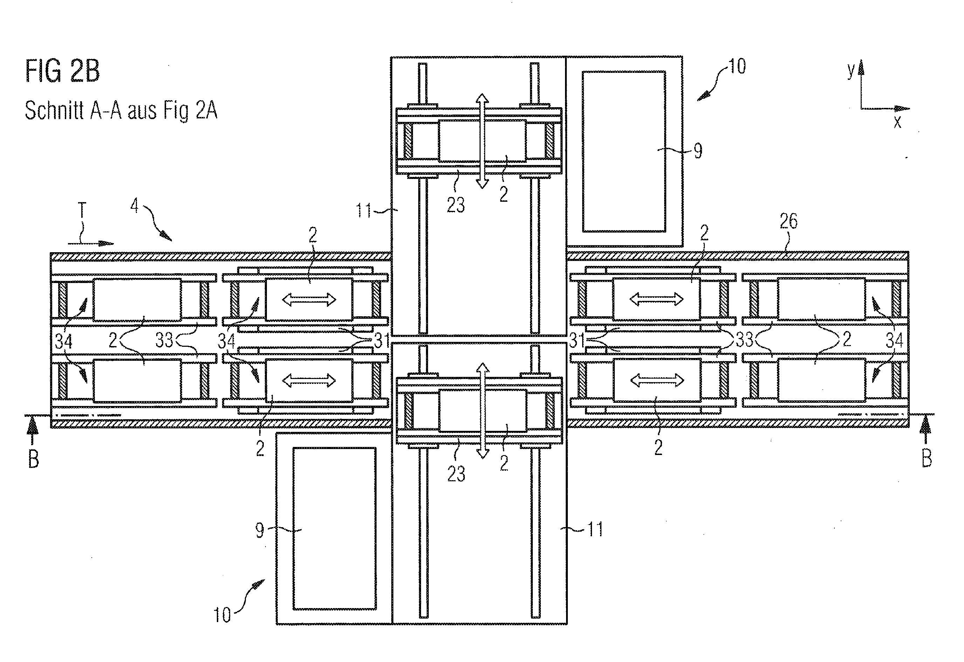

Die Figuren 2a und 2b zeigen schematisch einen Ausschnitt des Logistikmoduls 4, wobei die einzelnen Elemente der Verbindungseinrichtung 17 detailliert ausgeführt sind. Während Figur 2a eine Schnittdarstellung des Logistikmoduls 4 i in einer Seitenansicht zeigt, ist in Figur 2b das Logistikmodul 4 in einer Draufsicht dargestellt:
In einem Chassis 26 sind mehrere Transportabschnitte 34 in Transportrichtung T hintereinander angeordnet, wobei sie eine Transportstrecke bilden zum Transport der Substrate 2 in x-Richtung bilden. Jeder Transportabschnitt 34 weist hierzu ein Paar nebeneinander angeordneter Transportriemen 33 auf, welche um Rollen geführt sind und auf denen das Substrat 2 aufliegt. Werden die Transportriemen 33 zweier aufeinander folgender Transportabschnitte 34 angetrieben, so kann ein Substrat 2 von einem Transportabschnitt 34 an den nachfolgenden Transportabschnitt 34 übergeben werden. Es ist jedoch auch möglich, Greifer vorzusehen, welche die Substrate 2 vorzugsweise an ihren seitlichen Bereichen greifen und fortbewegen.

Ferner ist es möglich, die Transportabschnitte 34 mehrstöckig auszuführen. Dies ist insbesondere dann vorteilhaft, wenn eine Transportspur des Logistikmoduls 4 als By-pass Strecke genutzt werden soll, auf der Substrate 2 an anderen Substraten 2 vorbeigeführt werden können. Mittels der Transportstrecke können Substrate 2 den an das Logistikmodul 4 angekoppelten Robotermodulen 10 zugeführt bzw. von diesen abgeführt werden. Zur Abstützung des Chassis 26 gegenüber dem Untergrund sind mehrere Maschinenfüße unterhalb des Chassis 26 flächig angeordnet.

Der in der Mitte dargestellte Transportabschnitt 34 ist auf einer Verschiebeeinrichtung 23 angeordnet, welche in einer y-Richtung, die vorzugsweise orthogonal zur Transportrichtung T der Substrate 2 angeordnet ist, verfahren werden kann. Die Verschiebeeinrichtung 23 ist dabei Teil der Substrat-Transporteinrichtung 11 eines Robotermoduls 10 (siehe Figur 1). Die dargestellte Substrat-Transporteinrichtung 11 ist lediglich einspurig ausgeführt und weist daher nur eine Verschiebeeinrichtung 23 auf. Es ist jedoch auch möglich, die Substrat-Transporteinrichtung 11 zweispurig auszuführen. In diesem Fall sind entsprechend zwei Verschiebeeinrichtungen 23 in x-Richtung nebeneinander liegend vorzusehen.

Zu beiden Seiten der Verschiebeeinrichtung 23 sind zwei in Transportrichtung T bewegliche Transportabschnitte 34 angeordnet (dargestellt durch Doppelpfeile in x-Richtung). Die Transportabschnitte 34 sind hierzu an einer Gondel 31 befestigt, welche an einer linearen, stabartigen Führungseinrichtung 32 verschiebbar gelagert sind. Die Führungseinrichtung 32 ist oberhalb der Transportstrecke angeordnet und sich entlang der Transportrichtung T erstreckend ausgebildet. Mittels der beweglichen Transportabschnitte 34 kann ein Substrat 2 in Transportrichtung T auch an einen nachfolgenden Transportabschnitt 34 übergeben werden, wenn die normalerweise zwischen den beiden Transportabschnitten 34 angeordnete Verschiebeeinrichtung 23 quer zur Transportrichtung T verfahren wurde und für den Weitertransport des Substrats 2 innerhalb der Transportstrecke nicht zur Verfügung steht.

Die einzelnen Transportabschnitte 34 der Transportstrecke sind in einem fixen Rastermaß in Transportrichtung T hintereinander angeordnet. Entsprechend dieses modularen Aufbaus können auch die Robotermodule 10 unter Berücksichtigung dieses Rasters beliebig an das Logistikmodul 4 angekoppelt werden. Hierfür müssen gegebenenfalls lediglich einzelne Transportabschnitte 34 aus der Transportstrecke entfernt werden. Dabei ist darauf zu achten, dass die beweglichen Transportabschnitte 34 so angeordnet sind, dass der Weitertransport eines Substrats 2 in Transportrichtung T auch dann gewährleistet ist, wenn die Verschiebeeinrichtungen 23 quer zur Transportrichtung T verfahren wurde und somit nicht innerhalb der Transportstrecke für den Weitertransport der Substrate 2 zur Verfügung steht.

Weiterhin ist in Figur 2a die Verbindungseinrichtung 17, welche zwischen dem Logistikmodul 4 und jeweils einem angekoppelten Robotermodul 10 angeordnet ist, dargestellt. Sie weist Zuführmittel 20, 21, 22 auf, welche als Schnittstellen zur Zuführung von Betriebsstoffen für das jeweils angekoppelte Robotermodul 10 ausgebildet sind. Dadurch wird beispielsweise die Versorgung des Robotermoduls 10 mit Strom, Druckluft oder Informationen sichergestellt. Die Zuführmittel sind auf einem gemeinsamen Grundelement angeordnet, so dass sie mit den roboterseitigen Verbindungselementen der Verbindungseinrichtung 17 schnell und einfach verbunden werden können. Benötigt ein Robotermodul 10 darüber hinaus weitere Betriebsstoffe, so können diese ebenfalls mittels geeigneter Zuführmittel über die Verbindungseinrichtung 17 bereitgestellt werden. Aus Gründen der Ergonomischen Bedienbarkeit kann die Verbindungseinrichtung 17 sowohl auf Seiten des Logistikmoduls 4 als auch auf Seiten der Robotermodule 10 flexibel herausziehbar gestaltet werden.

Die in die Transportstrecke des Logistikmoduls 4 hineinragende Substrat-Transporteinrichtung 11 mit der quer zur Transportrichtung T verfahrbaren Verschiebeeinrichtungen 23 stellen zusammen mit den verschiebbaren Transportabschnitten 34 des Logistikmoduls 4 eine einfach zu realisierende Möglichkeit dar, Substrate 2 zwischen dem Logistikmodul 4 und einem angekoppelten Robotermodul 10 zu transferieren, ohne dass dabei die Transportstrecke und damit der Weitertransport der Substrate 2 unterbrochen wird.

In den Figuren 2a und 2b ist lediglich ein Ausschnitt des Logistikmoduls 4 und damit der Transportstrecke dargestellt. Auf Grund des modularen Aufbaus ist es jedoch problemlos möglich, die Transportstrecke um weitere Transportabschnitte 34 beliebig zu erweitern.

Anhand der Figuren 2a und 2b werden im Folgenden die erfindungsgemäßen Verfahren näher erläutert:
In einem ersten Schritt des Verfahrens zum Ankoppeln eines Robotermoduls 10 an das Logistikmodul 4 wird das Robotermodul 10 an dem Logistikmodul 4 angemeldet. Dies kann beispielsweise durch eine entsprechende Eingabe am Bedienterminal der Liniensteuerung 7 erfolgen. Hierdurch wird sichergestellt, dass der Transportabschnitt der Logistikmoduls 4, in den die Substrat-Transporteinrichtung 11 des Robotermoduls 10 eingekoppelt wird, nicht just in diesem Moment durch einen der verschiebbaren Transportabschnitte 34 blockiert wird.

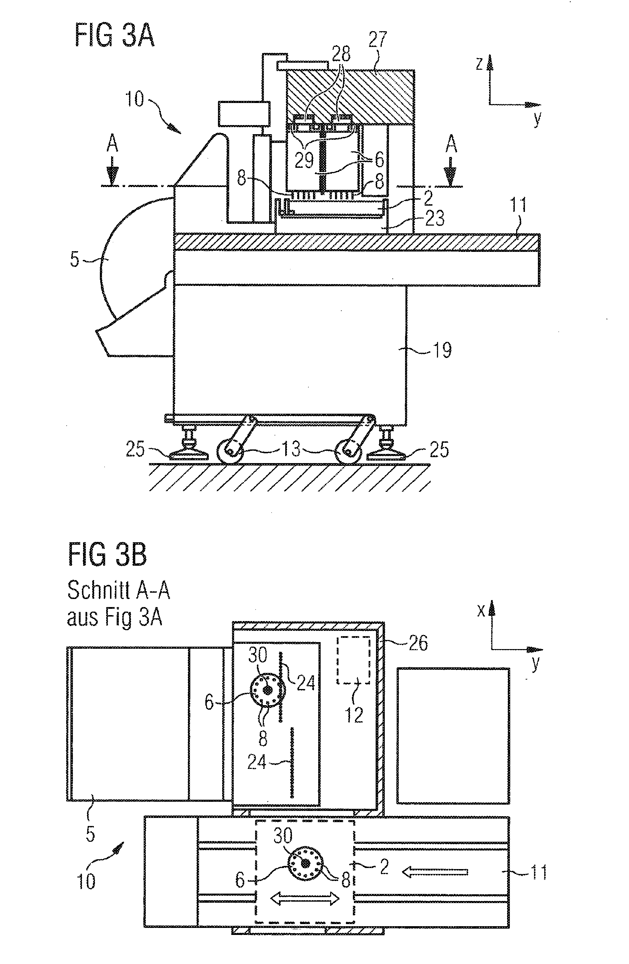

Anschließend wird zum eigentlichen Ankoppeln in einem zweiten Schritt das Robotermodul mittels schwenkbarer Transportrollen 13 (siehe Figur 3a) an die vorgesehene Position am Logistikmodul 4 gefahren, wobei die Substrat-Transporteinrichtung 11 in y-Richtung ausgerichtet wird. Hierzu wird das Robotermodul zunächst mittels der Zuführmittel 20, 21, 22 der Verbindungseinrichtung 17 mit den benötigten und vom Logistikmodul 4 bereitgestellten Betriebsstoffen versorgt. Dabei können auch Schnellverschlüsse oder gemeinsame Verschlusselemente verwendet werden, mit denen die Verbindungen mehrerer Betriebsmittel gleichzeitig geöffnet und geschlossen werden können. Anschließend werden die Transportrollen 13 eingeschwenkt und das Robotermodul 10 mittels einstellbarer Maschinenfüße 25 noch hinsichtlich der Höhenlage der Substrat-Transporteinrichtung 11 justiert. Das Robotermodul 10 wird beim Ankoppeln nicht mittels Zentriermitteln und Aufnahmedorne an das Logistikmodul 4 angehängt, sondern lediglich neben der Transportstrecke des Logistikmoduls 4 aufgestellt. Eine starre, mechanische Verbindung ist nicht erforderlich. Hierdurch wird die statische Belastung des Logistikmoduls 4 deutlich reduziert, so dass dessen Chassis 26 deutlich leichter ausgeführt werden kann, woraus eine geringere Flächenbelastung resultiert.

Zum Abkoppeln des Robotermoduls 10 vom Logistikmodul 4 wird in einem ersten Schritt das Robotermodul von dem Logistikmodul 4 abgemeldet. Dies kann wiederum durch eine entsprechende Eingabe am Bedienterminal der Liniensteuerung 7 erfolgen. Hierdurch wird gewährleistet, dass sich beim Abkoppeln kein Substrat 2 in einer Übergabeposition zwischen einem Transportabschnitt 34 des Logistikmoduls 4 und der Verschiebeeinrichtung 23 der Substrat-Transporteinrichtung 11 des Robotermoduls befindet.

Ist die Abmeldeprozedur freigegeben, beispielsweise durch eine entsprechende Meldung am Bedienterminal der Liniensteuerung 7, so wird anschließend in einem zweiten Schritt das Robotermodul 10 von dem Logistikmodul 4 abgekoppelt. Hierzu werden lediglich die Verbindungen für die Zuführmittel 20, 21, 22 wieder gelöst und die Transportrollen 13 des Robotermoduls 10 ausgeschwenkt. Das Robotermodul 10 wird dadurch leicht angehoben und kann auf einfache Art und Weise vom Logistikmodul entfernt werden. Das Logistikmodul muss währenddessen nicht ausgeschaltet werden. Auch ist es nicht notwendig, alle Transportabschnitte 34 anzuhalten. Lediglich diejenigen Transportabschnitte 34, welche direkt an die Substrat-Transporteinrichtung 11 des Robotermoduls 10 angrenzen, werden dahingehend beeinflusst, dass der in Transportrichtung T vorgelagerte Transportabschnitt 34 kein Substrat 2 weitergeben kann, sowie der in Transportrichtung T nachgelagerte Transportabschnitt 34 kein Substrat 2 in Empfang nehmen kann. Alle übrigen an das Logistikmodul 4 angekoppelten Robotermodule 10 können ohne Unterbrechung weiter durch das Logistikmodul bedient werden.

Auf diese Weise kann ein Robotermodul 10 während des laufenden Betriebs des Logistikmoduls an dieses angekoppelt oder von diesem abgekoppelt werden, ohne dass hierdurch der Betrieb des verbleibenden Fertigungssystems 1 unterbrochen wird.

In den Figuren 3a und 3b ist eine mögliche Ausführungsform des Robotermoduls 10 als Bestückautomat schematisch in einer Draufsicht sowie in einer Seitenansicht dargestellt.

Der Bestückautomat 1 weist einen Träger 27 auf, an dem zwei Bestückköpfe 6 in einer x-Richtung verfahrbar angeordnet sind. Der Träger 27 selbst ist mit einem Maschinengrundkörper 19 des Robotermoduls 10 fest verbunden und dient ausschließlich der linearen Führung der Bestückköpfe 6 in x-Richtung. Es ist jedoch ebenso möglich, zur Positionierung der Bestückköpfe 6 relativ zu dem zu bestückenden Substrat 2 ein x/y-Positioniersystem zu verwendenden. In diesem Fall ist der Träger 27 in y-Richtung verfahrbar auszubilden. Dies ist jedoch nicht zwingend erforderlich. Die Verwendung eines nicht verfahrbaren, am Maschinengrundkörper 19 fixierten Trägers 27 hat den Vorteil, dass die Anordnung zur Positionierung der Bestückköpfe 6 sehr steif ausgeführt werden kann. Die zu verfahrende Masse kann dadurch gering gehalten werden, was bei den hohen dynamischen Anforderungen zu einer reduzierten Schwingungsneigung und damit zu einer verbesserten Genauigkeit bei der Bestückung führt.

Ebenfalls fest mit dem Maschinengrundkörper 16 verbunden ist die Substrat-Transporteinrichtung 11, welche zum Transport eines Substrats 2 in einer y-Richtung vorgesehen ist. Hierzu weist die Substrat-Transporteinrichtung 11 eine Verschiebeeinrichtung 23 in Gestalt eines Schlittens auf, auf der das Substrat 2 ortsfest fixiert werden kann. Die Verschiebeeinrichtung 23 verfügt über einen Antrieb (nicht dargestellt), mit dessen Hilfe sie gemeinsam mit dem fixierten Substrat 2 in y-Richtung exakt positioniert werden kann. Ist eine hohe Positioniergenauigkeit gefordert kommen für den Antrieb beispielsweise Linearantriebe in Betracht. Andernfalls können auch alternative Antriebsformen, beispielsweise Spindelantriebe, eingesetzt werden. Mit Hilfe von Zuführeinrichtungen 5 können Bauelemente 3 an definierten Abholpositionen 24 bereitgestellt und von den Bestückköpfen 6 abgeholt werden. Ferner weist das als Bestückautomat ausgebildete Robotermodul 10 noch Maschinenfüße 25 zum sicheren Aufstellen innerhalb des Fertigungssystems 1, sowie schwenkbare Transportrollen 13 auf, welche einen Standortwechsel des Robotermoduls 10, beispielsweise zu Wartungs-, Reparatur- oder Rüstzwecken, erleichtern.

Zum Verfahren der Bestückköpfe 6 in x-Richtung sind jeweils Führungselemente 29 sowie Antriebseinheiten 28 zwischen dem feststehenden Träger 27 und dem jeweiligen Bestückkopf 6 vorgesehen. Die beiden Bestückköpfe 6 sind hier als Rotationsköpfe ausgebildet, welche eine Drehachse 30 sowie einen um diese Drehachse 30 drehbaren Rotor 16 aufweisen, an dem jeweils mehrere Halteeinrichtungen 8 angeordnet sind. Die Drehachse 30 ist dabei in einer z-Richtung, senkrecht zu einer Ebene des Substrats 2, orientiert, welche durch die zu bestückende Substratoberfläche bestimmt wird. Die Halteeinrichtungen 8 sind in einer Ebene parallel zur Ebene des Substrats 2 am Rotor angeordnet und in der z-Richtung verschiebbar, so dass Bauelemente 3 an den Abholpositionen 24 aufgenommen und an ihren jeweiligen vordefinierten Bestückpositionen auf dem

Substrat 2 abgesetzt werden können. Durch die Rotationsbewegung der am Rotor 16 angeordneten Halterichtungen 8 entsteht relativ zum Substrat 2 eine zusätzliche y-Achse für die Halterichtungen 8, mit deren Hilfe die Positionierung in y-Richtung realisiert wird.

Die beiden Bestückköpfe 6 sind im vorliegenden Fall am Träger 27 hängend dargestellt. Es ist jedoch ebenso möglich, die Bestückköpfe 6 seitlich am Träger 27 anzuordnen. Ferner ist es ebenso möglich, die Bestückköpfe 6 als Zeilenköpfe auszubilden, bei denen die Halteeinrichtungen in einer Reihe parallel zur Ebene des Substrats 2 angeordnet sind. In diesem Fall müssten die Zeilenköpfe dann jedoch eine zusätzliche Schwenk- oder Drehachse aufweisen, welche ebenfalls senkrecht zur Substratebene orientiert ist und eine Bewegung der Halteeinrichtungen 8 in einer weiteren Ebene parallel zur Substratebene ermöglicht.

Das als Bestückautomat dargestellte Robotermodul 10 kann sowohl als "stand-alone"-Vorrichtung oder aber innerhalb eines modularen Fertigungssystems 1 betrieben werden. Die Steuerung des Robotermoduls 10 im "stand-alone" Betrieb kann mittels der lokalen Steuereinheit 12 realisiert werden. Bei einem Einsatz innerhalb des Fertigungssystems 1 wird die lokale Steuereinrichtung 12 über das Logistikmodul 4 mit der Liniensteuerung 7 (siehe Figur 1) verbunden. Die Steuerung des Robotermoduls 10, beispielsweise die Verfahrbewegungen der Bestückköpfe 6, erfolgt dabei weiterhin mittels der lokalen Steuereinheit 12. Übergeordnete Aufgaben, beispielsweise die Belegungsplanung der einzelnen Robotermodule 10 eines Fertigungssystems 1 oder das Vorgehen zur Behebung von Störungen innerhalb des Fertigungssystems 1, wird mittels der Liniensteuerung 7 an die einzelnen Robotermodule 10 kommuniziert.

Mit Hilfe des in den Figuren 3a und 3b dargestellten Robotermoduls 10 ist es möglich, ein Substrat 2 streifenweise zu bestücken. Hierunter ist zu verstehen, dass mehrere Bauelemente 3 auf ihren vordefinierten Bestückpositionen innerhalb eines Streifens des Substrats 2 abgesetzt werden können, ohne dass hierzu das Substrat 2 in y-Richtung verfahren werden muss. Die Positionierung des jeweils abzusetzenden Bauelements 3 relativ zu seiner Bestückposition auf dem Substrat 2 in y-Richtung erfolgt durch eine geeignete Bewegung der betreffenden Halteeinrichtung am Bestückkopf 6, im dargestellten Fall durch eine Drehung des Rotors 16 um die Drehachse 30. Eventuell erforderliche Lagekorrekturen in x-Richtung erfolgen durch ein Verschieben des jeweiligen Bestückkopfs 6 entlang der zugeordneten Führungselemente 29.

Damit kann jeder der beiden Bestückköpfe 6 einen Streifen auf dem Substrat 2 autark bestücken, ohne dabei den anderen Bestückkopf 6 zu behindern. Sind die Führungselemente 29 der beiden Bestückköpfe 6 entsprechend eng aneinander angeordnet, so ist es mittels dieser Anordnung möglich, einen Streifenabschnitt, welcher ungefähr doppelt so groß ist wie der Durchmesser eines Bestückkopfs 6, abzüglich eines Sicherheitsabstands zwischen den beiden Bestückköpfen 6, vollständig zu bestücken, ohne dabei das Positioniersystem 7 oder das Substrat 2 verfahren zu müssen. Erst nach einer vollständigen Bestückung der den Bestückköpfen 6 zugeordneten Streifen ist dann ein Weitertakten des Substrats 2 in y-Richtung erforderlich.

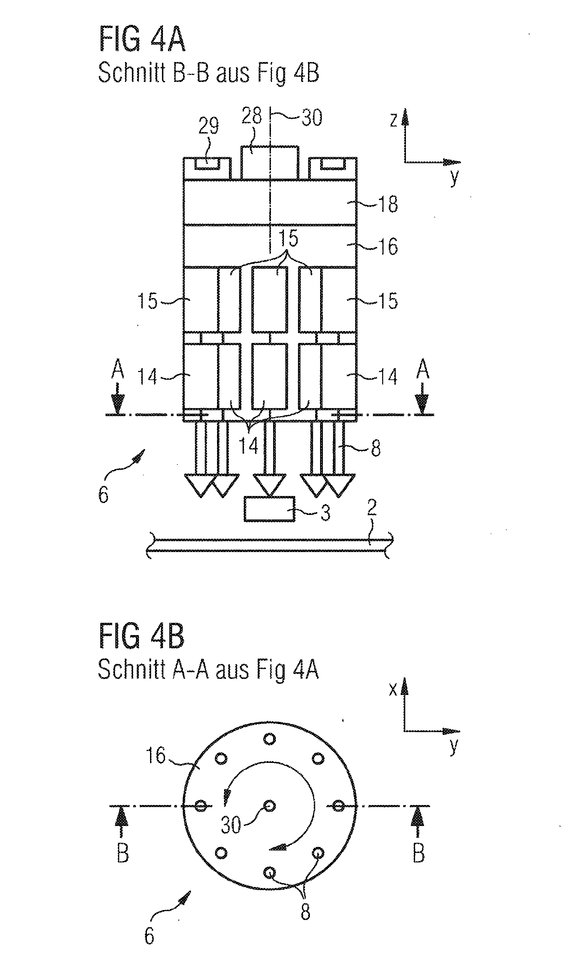

Die Figuren 4a und 4b zeigen eine mögliche Ausführungsform des Bestückkopfs 6 als Revolverkopf in Grund- und Aufriss, welche für eine streifenweise Bestückung eines Substrats 2 geeignet ist. Der Revolverkopf 6 ist rotationssymmetrisch aufgebaut und weist einen Stator 18 sowie einen Rotor 16 auf, welcher um eine Drehachse 30 drehbar am Stator 18 gelagert ist. Ferner sind am Stator 18 Führungselemente 29 sowie Teile einer Antriebseinheit 28 angeordnet, mit denen der Bestückkopf 6 an einem Träger 27 (siehe Figuren 3a und 3b) verfahrbar angebracht werden kann. Am Rotor 16 sind mehrere Halteeinrichtungen 8 äquidistant auf einer Kreisbahn angeordnet, deren Mittelpunkt die Drehachse 30 bildet. Die Halteeinrichtungen 8 sind zur Handhabung von Bauelementen 3 vorgesehen und verfügen jeweils über einen eigenen Drehantrieb 14 sowie über einen eigenen z-Antrieb 15. Während die Drehantriebe 14 zur Korrektur der Winkellage des jeweils gehaltenen Bauelements 3 um die z-Achse ausgebildet sind, kann mit Hilfe des jeweiligen z-Antriebs eine Zustellbewegung der jeweiligen Halteeinrichtung in z-Richtung durchgeführt werden.

Nachdem bei der streifenweisen Bestückung weder das Substrat 2 noch der Träger 27 verfahren werden, erfolgt eine x/y-Positionierung der gehaltenen Bauelemente 3 über ihren Bestückpositionen auf dem Substrat 2 durch eine Verfahrbewegung des Revolverkopfs 6 in x-Richtung sowie eine Rotationsbewegung des Rotors 16 um die Drehachse 30. Durch die Rotationsbewegung der Halterichtungen 8 entsteht in Bezug zum Substrat 2 eine zusätzliche y-Achse, mit deren Hilfe die Positionierung in y-Richtung erfolgt. Eine ggf. notwendige Korrektur der x-Koordinate wird mittels einer Verfahrbewegung des Revolverkopfs 6 entlang des Trägers 7 ermöglicht.

### Bezugszeichenliste

- 1: Bestückungslinie / Fertigungssystem
- 2: Substrat
- 3: Bauelement
- 4: Logistikmodul
- 5: Zuführeinrichtung
- 6: Bestückkopf
- 7: Liniensteuerung
- 8: Halteeinrichtung
- 9: Bearbeitungseinrichtung
- 10: Robotermodul
- 11: Substrat-Transporteinrichtung
- 12: Steuereinheit
- 13: Rolle
- 14: Drehantrieb
- 15: z-Antrieb
- 16: Rotor
- 17: Verbindungseinrichtung
- 18: Stator
- 19: Maschinengrundkörper
- 20: Elektrische Schnittstelle
- 21: Pneumatische Schnittstelle
- 22: Informatorische Schnittstelle
- 23: Verschiebeeinrichtung
- 24: Abholposition
- 25: Maschinenfuß
- 26: Chassis
- 27: Träger
- 28: Antriebseinheit
- 29: Führungselement
- 30: Drehachse
- 31: Gondel
- 32: Führungseinrichtung
- 33: Transportriemen
- 34: Transportabschnitt
- T: Transportrichtung

## Patentansprüche

1. Anordnung zum Transport von Substraten (2), welche mit Bauelementen (3) bestückbar sind,
- mit einem Logistikmodul (4), welches zum Transport der Substrate (2) bei einer Bestückungslinie (1) ausgestaltet ist,
- mit einer ersten Verbindungseinrichtung (17), welche derart ausgestaltet ist, dass Substrate (2) zur Bearbeitung vom Logistikmodul (4) an ein erstes Robotermodul (10) übergebbar sind,
**dadurch gekennzeichnet,**
**dass** die erste Verbindungseinrichtung (17) zum an- und/oder abkoppeln des ersten Robotermoduls (10) während eines Betriebs des Logistikmoduls (4) ausgestaltet ist.

2. Anordnung nach Anspruch 1,
**dadurch gekennzeichnet,**
**dass** die erste Verbindungseinrichtung (17) derart ausgestaltet ist, dass bearbeitete Substrate (2) vom Robotermodul (10) an das Logistikmodul (4) übergebbar sind.

3. Anordnung nach einem der Ansprüche 1 oder 2,
**dadurch gekennzeichnet,**
**dass** am Logistikmodul eine weitere Verbindungseinrichtung (17) vorgesehen ist, mit der ein weiteres Robotermodul (10) an- und/oder abkoppelbar ist, so dass je nach Kopplung des ersten oder zweiten Robotermoduls eine Funktionalität der Bestückungslinie (1) erhalten bleibt.

4. Anordnung nach einem der Ansprüche 1 bis 3,
**dadurch gekennzeichnet,**
**dass** die Verbindungseinrichtung (17) Zuführmittel (20, 21, 22) aufweist, die zur Zuführung von Betriebsstoffen vom Logistikmodul zum Robotermodul (10) ausgestaltet sind.

5. Anordnung nach einem der Ansprüche 1 bis 4,
**dadurch gekennzeichnet,**
- **dass** das Logistikmodul (4) mit einer Liniensteuerung (7) verbunden ist,
- **dass** jedes Robotermodul (10) eine ihm zugeordnete Steuereinheit (12) aufweist, mit der zumindest eine Funktion des jeweiligen Robotermoduls (10) steuerbar ist, und
- **dass** die Verbindungseinrichtung (17) zum Datenaustausch zwischen der Liniensteuerung (7) einerseits und einer ausgewählten Steuereinheit (12) andererseits ausgebildet ist.

6. Anordnung zum Handhaben von Substraten,
- mit einem ersten Robotermodul (10), welches zum Handhaben der Substraten (2) ausgestaltet ist,
- mit einer ersten Verbindungseinrichtung (17), welche derart ausgestaltet ist, dass Substrate (2) zur Bearbeitung von einem Logistikmodul (4) einer Bestückungslinie (1) an das erstes Robotermodul (10) übergebbar sind,
**dadurch gekennzeichnet,**
**dass** die erste Verbindungseinrichtung (17) zum an- und/oder abkoppeln des ersten Robotermoduls (10) während eines Betriebs des Logistikmoduls (4) ausgestaltet ist.

7. Anordnung nach Anspruch 6,
**dadurch gekennzeichnet,**
**dass** eine zweite Verbindungseinrichtung (17) vorgesehen ist, mit der ein zweites Robotermodul (10) an das Logistikmodul (4) an- und/oder abkoppelbar ist, so dass je nach Koppelung des ersten oder zweiten Robotermoduls (10) eine Funktionalität der Bestückungslinie (1) erhalten bleibt.

8. Anordnung nach Anspruch 6 oder 7,
**dadurch gekennzeichnet,**
**dass** die Verbindungseinrichtung (17) Zuführmittel (20, 21, 22) aufweist, welche zur Zuführung von Betriebsstoffen vom Logistikmodul zum Robotermodul (10) ausgestaltet sind.

9. Anordnung nach einem der Ansprüche 6 bis 8,
**dadurch gekennzeichnet,**
- **dass** bei einem angekoppelten Robotermodul (10) das Logistikmodul (4) mit einer Liniensteuerung (7) verbunden ist,
- **dass** jedes Robotermodul (10) eine ihm zugeordnete Steuereinheit (12) aufweist, mit der zumindest eine Funktion des angekoppelten Robotermoduls (10) steuerbar ist,
- **dass** die Verbindungseinrichtung (17) zum Datenaustausch zwischen der Liniensteuerung (7) einerseits und einer ausgewählten Steuereinheit (12) andererseits ausgebildet ist.

10. Anordnung nach Anspruch 9,
**dadurch gekennzeichnet,**
- **dass** ein abgekoppeltes Robotermodul (10) mittels der ihm zugeordneten Steuereinheit (12) unabhängig vom Logistikmodul (4) betreibbar ist.

11. Anordnung nach einem der Ansprüche 6 bis 10,
**dadurch gekennzeichnet,**
**dass** das Robotermodul (10) mehrere Rollen (13) aufweist, mittels derer es in einer Richtung quer zum Logistikmodul (4) verfahrbar ist.

12. Anordnung nach einem der Ansprüche 6 bis 11,
**dadurch gekennzeichnet,**
**dass** das Robotermodul (10) zur Kontrolle der Substrate (2) ausgebildet ist.

13. Anordnung nach einem der Ansprüche 6 bis 11,
**dadurch gekennzeichnet,**
**dass** das Robotermodul (10) zum Aufbringen eines viskosen Mediums auf die Substrate (2) ausgebildet ist.

14. Anordnung nach einem der Ansprüche 6 bis 11,
**dadurch gekennzeichnet,**
- **dass** das Robotermodul (10) als Bestückautomat zum Bestücken der Substrate (2) mit Bauelementen (3) ausgebildet ist.

15. Anordnung nach Anspruch 14,
**dadurch gekennzeichnet,**
- **dass** das Robotermodul (10) zumindest einen Bestückkopf (6) aufweist, welcher ausschließlich in einer x-Richtung, welche im Wesentlichen parallel zu einer Ebene des Substrats verläuft, bewegbar ist,
- **dass** jeder Bestückkopf (6) mindestens eine Halteeinrichtung (8) zum Handhaben der Bauelemente (3) aufweist, welche in einer z-Richtung senkrecht zur Ebene des Substrats (2) relativ zum Bestückkopf (6) verschiebbar am Bestückkopf (6) angeordnet ist,
- **dass** das Robotermodul (10) eine Verschiebeeinrichtung(23) aufweist, mittels der das zu bestückende Substrat (2) ausschließlich in einer y-Richtung bewegbar ist, welche im Wesentlichen senkrecht zur z-Richtung und winkelig zu der x-Richtung verläuft.

16. Anordnung nach Anspruch 15,
**dadurch gekennzeichnet,**
- **dass** das Robotermodul (10) zumindest einen Bestückkopf (6) aufweist, welcher in einer x-Richtung sowie in einer y-Richtung, welche im Wesentlichen parallel zu einer Ebene des Substrats sowie winkelig zueinander verlaufen, bewegbar am Robotermodul (10) angeordnet ist,
- **dass** jeder Bestückkopf (6) mindestens eine Halteeinrichtung (8) zum Handhaben der Bauelemente (3) aufweist, welche in einer z-Richtung senkrecht zur Ebene des Substrats (2) relativ zum Bestückkopf (6) verschiebbar am Bestückkopf (6) angeordnet ist.

17. Anordnung nach einem der Ansprüche 15 oder 16,
**dadurch gekennzeichnet,**
**dass** mindestens einer der Bestückköpfe (6) mehrere Halteeinrichtungen (8) aufweist, welche zueinander parallel in einer Ebene parallel zur Ebene des Substrats (2) angeordnet sind.

18. Anordnung nach einem der Ansprüche 15 bis 17,
**dadurch gekennzeichnet,**
**dass** jede Halteeinrichtung (8) mindestens eines der Bestückköpfe (6) über einen eigenen Drehantrieb (14) verfügt, mit dessen Hilfe ein aufgenommenes Bauelement (3) um eine Achse senkrecht zur Ebene des Substrats (2) drehbar ist.

19. Anordnung nach einem der Ansprüche 15 bis 17,
**dadurch gekennzeichnet,**
**dass** jede Halteeinrichtung (8) mindestens eines der Bestückköpfe (6) über einen eigenen z-Antrieb (15) verfügt, mit dessen Hilfe ein aufgenommenes Bauelement (3) in der z-Richtung senkrecht zur Ebene des Substrats (2) verfahrbar ist.

20. Anordnung nach einem der Ansprüche 15 bis 19,
**dadurch gekennzeichnet,**
- **dass** mindestens einer der Bestückköpfe (6) einen um eine Achse senkrecht zur Ebene des Substrats (2) drehbaren Rotor (16) aufweist, und
- **dass** der Bestückkopf (6) mindestens zwei Halteeinrichtungen (8) aufweist, welche am Rotor (16) angeordnet sind.

21. Anordnung zum Herstellen elektronischer Baugruppen,
- mit einem Logistikmodul (4) nach einem der Ansprüche 1 bis 5
- mit zumindest einem mit dem Logistikmodul (4) gekoppelten Robotermodul (10) nach einem der Ansprüche 6 bis 20,
bei der das Robotermodul (10) während des Betriebs des Logistikmoduls (4) ankoppelbar und/oder abkoppelbar ist.

22. Verfahren zum Handhaben von Substraten (2) mittels einer Anordnung nach Anspruch 21, insbesondere zum Bestücken der Substrate (2) mit Bauelementen (3),
wobei die Anordnung ein Logistikmodul (4) zum Transport der Substrate (2) sowie mindestens ein Robotermodul (10) zum Handhaben der Substrate (2) umfasst,
- bei dem in einem ersten Schritt das Robotermodul (10) von dem Logistikmodul (4) abgemeldet wird, und
- bei dem in einem zweiten Schritt das abgemeldete Robotermodul (10) während des Betriebs des Logistikmoduls (4) von diesem abgekoppelt wird.

23. Verfahren nach Anspruch 22,
- Bei dem die Anordnung eine Liniensteuerung (7) zur Koordination der Abläufe zwischen dem Logistikmodul (4) und des mindestens einen Robotermoduls (10) aufweist, und
- bei dem das Robotermodul (10) an der Liniensteuerung (7) von dem Logistikmodul (4) abgemeldet wird.

24. Verfahren nach einem der Ansprüche 22 oder 23,
bei dem das Robotermodul (10) nach dem Abkoppeln vom Logistikmodul (4) abgerüstet und/oder gewartet wird.

25. Verfahren zum Handhaben von Substraten (2) mittels einer Anordnung nach Anspruch 21, insbesondere zum Bestücken der Substrate (2) mit Bauelementen (3),
wobei die Anordnung ein Logistikmodul (4) zum Transport der Substrate (2) sowie mindestens ein Robotermodul (10) zum Handhaben der Substrate (2) umfasst,
- bei dem in einem ersten Schritt das Robotermodul (10) an dem Logistikmodul (4) angemeldet wird,
- bei dem in einem zweiten Schritt das angemeldete Robotermodul (10) während des Betriebs des Logistikmoduls (4) an das Logistikmodul (4) angekoppelt wird.

26. Verfahren nach Anspruch 25,
bei dem das Robotermodul (10) vor dem Ankoppeln an das Logistikmodul (4) gerüstet und/oder getestet wird.

## Claims

1. Arrangement for the transport of substrates (2), which can be assembled with components (3), the arrangement comprising
a logistic module (4), which is configured for transporting the substrates (2) at an assembly line (1),
a first connection device (17), which is configured in such a manner, that for processing substrates (2) can be handled over from the logistic module (4) to a first robot module (10),
**characterized in that**
the first connection device (17) is configured for coupling and/or for decoupling the first robot module (10) during an operation of the logistic module (4).

2. Arrangement as set forth in claim 1, **characterized in that**
the first connection device (17) is configured in such a manner that processed substrates (2) can be handled over from the robot module (10) to the logistic module (4).

3. Arrangement as set forth in any one of the claims 1 or 2, **characterized in that** at the logistic module there is provided a further connection device (17), with which a further robot module (10) is coupleable and/or decoupleable, so that depending on the coupling of the first or the second robot module a functionality of the assembly line (1) is maintained.

4. Arrangement as set forth in any one of the claims 1 to 3, **characterized in that** the connection device (17) comprises feeding means (20, 21, 22), which are configured for feeding operating materials from the logistic module to the robot module (10).

5. Arrangement as set forth in any one of the claims 1 to 4, **characterized in that**
the logistic module (4) is connected to a line control (7),
each robot module (10) comprises the control unit (12) being assigned to it, with which at least one function of the respective robot module (10) is controllable, and
the connection device (17) is configured for exchanging data between the line control (7) on the one hand and a selected control unit (12) at the other hand.

6. Arrangement for handling substrates, the arrangement comprising
a first robot module (10), which is configured for handling the substrates (2),
a connection device (17), which is configured in such a manner, that substrates (2) for processing can be handled over from a logistic module (4) of an assembly line (1) to the first robot module (10),
**characterized in that**
the first connection device (17) is configured for coupling and/or for decoupling the first robot module (10) during an operation of the logistic module (4).

7. Arrangement as set forth in claim 6, **characterized in that** there is provided a second connection device (17), with which the second robot module (10) is coupleable to and/or the comparable from the logistic module (4), such that depending on a coupling of the first or the second robot module (10) a functionality of the assembly line (1) is maintained.

8. Arrangement as set forth in claim 6 or 7, **characterized in that** the connection device (17) comprises feeding means (20, 21, 22), which are configured for feeding operating materials from the logistic module to the robot module (10).

9. Arrangement as set forth in any one of the claims 6 to 8, **characterized in that**
with a coupled robot module (10) the logistic module (4) is connected with the line control (7),
each robot module (10) comprises a control unit (12) being assigned to it, with which at least one function of the coupled robot module (10) is controllable,
the connection device (17) is configured for exchanging data between the line control (7) on the one hand and a selected control unit (12) on the other hand.

10. Arrangement as set forth in claim 9, **characterized in that** a decoupled robot module (10) can be operated by means of the control unit (12) being assigned to it independently from the logistic module (4).

11. Arrangement as set forth in any one of the claims 6 to 10, **characterized in that**
the robot module (10) comprises several rollers (13), with which it is movable along a direction crosswise to the logistic module (4).

12. Arrangement as set forth in any one of the claims 6 to 11, **characterized in that**
the robot module (10) is configured for controlling the substrates (2).

13. Arrangement as set forth in any one of the claims 6 to 11, **characterized in that**
the robot module (10) is configured for applying a viscous medium onto the substrates (2).

14. Arrangement as set forth in any one of the claims 6 to 11, **characterized in that**
the robot module (10) is realized as an assembly machine for assembling the substrates (2) with components (3).

15. Arrangement as set forth in claim 14, **characterized in that**
the robot module (10) comprises at least one assembly head (6), which is movable solely along an x-direction, which runs substantially parallel to a plane of the substrate,
each assembly head (6) comprises at least one holding device (8) for handling the components (3), which holding device (8) is arranged at the assembly head (6) in a displaceable manner along a z-direction being perpendicular to the plane of the substrate (2) relative to the assembly head (6),
the robot module (10) comprises a displacement device (23), by means of which the substrate (2) being supposed to be assembled is movable solely along the y-direction, which runs substantially perpendicular with respect to the z-direction and angularly with respect to the x-direction.

16. Arrangement as set forth in claim 15, **characterized in that**
the robot module (10) comprises at least one assembly head (6), which is arranged in a movable manner at the robot module (10) along an x-direction as well as along a y-direction, which run substantially parallel to a plane of the substrate as well as angularly with respect to each other,
each assembly head (6) comprises at least one holding device (8) for handling the components (3), which holding device (8) is arranged at the assembly head (6) in a displaceable manner along a z-direction being perpendicular to the plane of the substrate (2) with respect to the assembly head (6).

17. Arrangement as set forth in any one of the claims 15 or 16, **characterized in that**
at least one of the assembly heads (6) comprises several holding devices (8), which are arranged in a parallel manner with respect to each other within a plane being parallel to the plane of the substrate (2).

18. Arrangement as set forth in any one of the claims 15 to 17, **characterized in that**
each holding device (8) of at least one assembly head (6) is equipped with an own rotary drive (14), with the aid of which a received component (3) is rotatable around an axis being perpendicular to the plane of the substrate (2).

19. Arrangement as set forth in any one of the claims 15 to 17, **characterized in that**
each holding device (8) of at least one assembly head (6) is equipped with an own z-drive (15), with the aid of which a received component (3) is movable along the z-direction perpendicular to the plane of the substrate (2).

20. Arrangement as set forth in any one of the claims 15 to 19, **characterized in that**
at least one of the assembly heads (6) comprises a rotor (16) being rotatable around an axis being perpendicular to the plane of the substrate (2), and
the assembly head (6) comprises at least two holding devices (8) which are arranged at the rotor (16).

21. Arrangement for manufacturing electronic assembly groups, the arrangement comprising
a logistic module (4) as set forth in any one of the claims 1 to 5,
at least one robot module (10) as set forth in any one of the claims 6 to 20, which robot module (10) is coupled with the logistic module (4),
wherein the robot module (10) is coupleable and/or decoupleable during an operation of the logistic module (4).

22. Method for handling substrates (2) by means of an arrangement as set forth in claim 21, in particular for assembling the substrates (2) with components (3), wherein
the arrangement includes a logistic module (4) for the transport of the substrates (2) as well as at least one robot module (10) for handling the substrates (2),
in which method in a first step the robot module (10) is unsubscribed from the logistic module (4), and
in which method in a second step the unsubscribed robot module (10) is decoupled during the operation of the logistic module (4).

23. Method as set forth in claim 22,
in which method the arrangement comprises a line control (7) for coordinating the processes between the logistic module (4) and the at least one robot module (10), and
in which method the robot module (10) is unsubscribed from the line control (7) by means of the logistic module (4).

24. Method as set forth in any one of the claims 22 or 23,
in which the robot module (10) is stripped down and/or maintained after the decoupling from the logistic module (4).

25. Method for handling substrates (2) by means of an arrangement as set forth in claim 21, in particular for assembling the substrates (2) with components (3), wherein the arrangement includes a logistic module (4) for the transport of the substrates (2) as well as at least one robot module (10) for handling the substrates (2),
in which method in a first step the robot module (10) is subscribed to the logistic module (4),
in which method in a second step the subscribed robot module (10) is coupled to the logistic module (4) during the operation of the logistic module (4).

26. Method as set forth in claim 25, in which the robot module (10) is set up and/or tested before the coupling to the logistic module (4).

## Revendications

1. Agencement de transport de substrats (2) qui peuvent être équipés d'éléments structurels (3),
- avec un module logistique (4) qui est configuré pour le transport des substrats (2) près d'une ligne d'équipement (1),
- avec un premier dispositif de liaison (17) qui est configuré de telle manière que des substrats (2) puissent être transmis pour le traitement du module logistique (4) à un premier module de robot (10),
**caractérisé en ce que**,
le premier dispositif de liaison (17) est configuré pour le couplage et/ou découplage du premier module de robot (10) pendant un fonctionnement du module logistique (4).

2. Agencement selon la revendication 1,
**caractérisé en ce que**,
le premier dispositif de liaison (17) est configuré de telle manière que des substrats traités (2) puissent être transmis du module de robot (10) au module logistique (4).

3. Agencement selon l'une quelconque des revendications 1 ou 2,
**caractérisé en ce**
**qu'**un autre dispositif de liaison (17) est prévu sur le module logistique, avec lequel un autre module de robot (10) peut être couplé et/ou découplé de sorte que selon le couplage du premier ou second module de robot, une fonctionnalité de la ligne d'équipement (1) soit maintenue.

4. Agencement selon l'une quelconque des revendications 1 à 3,
**caractérisé en ce que**,
le dispositif de liaison (17) présente des moyens d'amenée (20, 21, 22) qui sont configurés pour l'amenée de matières consommables du module logistique au module de robot (10).

5. Agencement selon l'une quelconque des revendications 1 à 4,
**caractérisé en ce que**,
- le module logistique (4) est relié à une commande de ligne (7),
- chaque module de robot (10) présente une unité de commande qui lui est associée (12), avec laquelle au moins une fonction du module de robot (10) respectif peut être commandée, et
- le dispositif de liaison (17) est réalisé pour l'échange de données entre la commande de ligne (7) d'une part et une unité de commande (12) sélectionnée d'autre part.

6. Agencement pour la manipulation des substrats
- avec un premier module de robot (10) qui est configuré pour la manipulation des substrats (2),
- avec un premier dispositif de liaison (17) qui est configuré de telle manière que des substrats (2) puissent être transmis pour le traitement d'un module logistique (4) d'une ligne d'équipement (1) au premier module logistique (10),
**caractérisé en ce que**,
le premier dispositif de liaison (17) est configuré pour le couplage et/ou découplage du premier module de robot (10) pendant un fonctionnement du module logistique (4).

7. Agencement selon la revendication 6,
**caractérisé en ce**
**qu'**un second dispositif de liaison (17) est prévu, avec lequel un second module de robot (10) peut être couplé et/ou découplé du module logistique (4) de sorte que selon le couplage du premier ou second module de robot (10), une fonctionnalité de la ligne d'équipement (1) soit maintenue.

8. Agencement selon la revendication 6 ou 7,
**caractérisé en ce que**,
le dispositif de liaison (17) présente des moyens d'amenée (20, 21, 22) qui sont configurés pour l'amenée de matières consommables du module logistique au module de robot (10).

9. Agencement selon l'une quelconque des revendications 6 à 8,
**caractérisé en ce que**,
- lorsqu'un module de robot est couplé (10), le module logistique (4) est relié à une commande de ligne (7),
- chaque module de robot (10) présente une unité de commande qui lui est associée (12), avec laquelle au moins une fonction du module de robot (10) couplé peut être commandée,
- le dispositif de liaison (17) est réalisé pour l'échange de données entre la commande de ligne (7) d'une part et une unité de commande sélectionnée (12) d'autre part.

10. Agencement selon la revendication 9,
**caractérisé en ce que**,
- un module de robot (10) découplé peut fonctionner à l'aide de l'unité de commande (12) qui lui est associée indépendamment du module logistique (4).

11. Agencement selon l'une quelconque des revendications 6 à 10,
**caractérisé en ce que**,
le module de robot (10) présente plusieurs rouleaux (13), à l'aide desquels il peut être déplacé dans un sens transversal au module logistique (4).

12. Agencement selon l'une quelconque des revendications 6 à 11,
**caractérisé en ce que**,
le module de robot (10) est réalisé pour le contrôle des substrats (2).

13. Agencement selon l'une quelconque des revendications 6 à 11,
**caractérisé en ce que**,
le module de robot (10) est réalisé pour l'application d'un agent visqueux sur les substrats (2).

14. Agencement selon l'une quelconque des revendications 6 à 11,
**caractérisé en ce que**,
- le module de robot (10) est réalisé comme un automate d'équipement pour l'équipement des substrats (2) avec des éléments structurels (3).

15. Agencement selon la revendication 14,
**caractérisé en ce que**,
- le module de robot (10) présente au moins une tête d'équipement (6) qui peut être déplacée exclusivement dans un sens x qui s'étend sensiblement parallèlement à un plan du substrat,
- chaque tête d'équipement (6) présente au moins un dispositif de retenue (8) pour la manipulation des éléments structurels (3) qui est disposée de manière coulissante dans un sens z perpendiculairement au plan du substrat (2) par rapport à la tête d'équipement (6) sur la tête d'équipement (6),
- le module de robot (10) présente un dispositif de coulissement (23), à l'aide duquel le substrat (2) à équiper est mobile exclusivement dans un sens y qui s'étend sensiblement perpendiculairement au sens z et angulairement au sens x.

16. Agencement selon la revendication 15,
**caractérisé en ce que**,
- le module de robot (10) présente au moins une tête d'équipement (6) qui est disposée de manière mobile sur le module de robot (10) dans un sens x ainsi que dans un sens y qui s'étendent sensiblement parallèlement à un plan du substrat ainsi qu'angulairement à celui-ci,
- chaque tête d'équipement (6) présente au moins un dispositif de retenue (8) pour la manipulation des éléments structurels (3) qui est disposé de manière coulissante dans un sens z perpendiculairement au plan du substrat (2) par rapport à la tête d'équipement (6) sur la tête d'équipement (6).

17. Agencement selon l'une quelconque des revendications 15 ou 16,
**caractérisé en ce**
**qu'**au moins l'une des têtes d'équipement (6) présente plusieurs dispositifs de retenue (8) qui sont disposés parallèlement les uns aux autres dans un plan parallèle au plan du substrat (2).

18. Agencement selon l'une quelconque des revendications 15 à 17,
**caractérisé en ce que**,
chaque dispositif de retenue (8) au moins d'une des têtes d'équipement (6) dispose d'un entraînement rotatif (14) propre, à l'aide duquel un élément structurel (3) reçu peut être tourné autour d'un axe perpendiculairement au plan du substrat (2).

19. Agencement selon l'une quelconque des revendications 15 à 17,
**caractérisé en ce que**,
chaque dispositif de retenue (8) au moins d'une des têtes d'équipement (6) dispose d'un propre entraînement z (15), à l'aide duquel un élément structurel reçu (3) peut être déplacé dans le sens z perpendiculairement au plan du substrat (2).

20. Agencement selon l'une quelconque des revendications 15 à 19,
**caractérisé en ce que**,
- au moins l'une des têtes d'équipement (6) présente un rotor (16) pouvant tourner autour d'un axe perpendiculairement au plan du substrat (2), et
- la tête d'équipement (6) présente au moins deux dispositifs de retenue (8) qui sont disposés sur le rotor (16).

21. Agencement pour la fabrication de composants électroniques,
- avec un module logistique (4) selon l'une quelconque des revendications 1à5,
- avec au moins un module de robot (10) couplé au module logistique (4) selon l'une quelconque des revendications 6 à 20,
pour lequel le module de robot (10) peut être couplé et/ou découplé pendant le fonctionnement du module logistique (4).

22. Procédé de manipulation de substrats (2) à l'aide d'un agencement selon la revendication 21, en particulier pour l'équipement des substrats (2) en éléments structurels (3),
l'agencement comportant un module logistique (4) pour le transport des substrats (2) ainsi qu'au moins un module de robot (10) pour la manipulation des substrats (2),
- pour lequel dans une première étape, le module de robot (10) est déconnecté du module logistique (4), et
- pour lequel dans une seconde étape, le module de robot déconnecté (10) est découplé pendant le fonctionnement du module logistique (4) de celui-ci.

23. Procédé selon la revendication 22,
- pour lequel l'agencement présente une commande de ligne (7) pour la coordination des opérations entre le module logistique (4) et l'au moins un module de robot (10), et
- pour lequel le module de robot (10) est déconnecté sur la commande de ligne (7) du module logistique (4).

24. Procédé selon l'une quelconque des revendications 22 ou 23, pour lequel le module de robot (10) est démonté et/ou entretenu après le découplage du module logistique (4).

25. Procédé de manipulation de substrats (2) à l'aide d'un agencement selon la revendication 21, en particulier pour l'équipement des substrats (2) en éléments structurels (3),
l'agencement comportant un module logistique (4) pour le transport des substrats (2) ainsi qu'au moins un module de robot (10) pour la manipulation des substrats (2),
- pour lequel dans une première étape, le module de robot (10) est connecté au module logistique (4),
- pour lequel dans une seconde étape, le module de robot connecté (10) est couplé pendant le fonctionnement du module logistique (4) au module logistique (4).

26. Procédé selon la revendication 25,
pour lequel le module de robot (10) est préparé et/ou testé avant le couplage au module logistique (4).
